(19) Europäisches Patentamt
European Patent Office
Office européen des brevets

(11) **EP 3 252 900 A1**

(12) **EUROPÄISCHE PATENTANMELDUNG**

(43) Veröffentlichungstag:
06.12.2017 Patentblatt 2017/49

(51) Int Cl.:
*H02H 1/00* (2006.01)          *G01R 31/12* (2006.01)

(21) Anmeldenummer: **17168392.3**

(22) Anmeldetag: **27.04.2017**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**MA MD**

(30) Priorität: **31.05.2016 DE 102016209445**

(71) Anmelder: **Siemens Aktiengesellschaft
80333 München (DE)**

(72) Erfinder:
• **Wenzlaff, Karsten
  01097 Dresden (DE)**
• **Meyer, Jörg
  01157 Dresden (DE)**
• **Schegner, Peter
  01259 Dresden (DE)**

(54) **STÖRLICHTBOGENERKENNUNGSEINHEIT**

(57) Die Erfindung betrifft eine Störlichtbogenerkennungseinheit für einen elektrischen Niederspannungsstromkreis, aufweisend mindestens einen Spannungssensor, zur periodischen Ermittlung von elektrischen Spannungswerten (u(n), u(k)) des elektrischen Stromkreises, der mit einer Auswerteeinheit verbunden ist, die derart ausgestaltet ist, dass fortlaufend eine erste Hälfte einer ersten Anzahl Spanungswerte (u(n), u(k)) zu einer ersten Teilsumme (TS1) und die zweite Hälfte an Spannungswerten (u(n), u(k)) zu einer zweiten Teilsumme (TS2) aufsummiert wird und eine Differenz (DU) beider Teilsummen ermittelt wird. Entweder wird einerseits die Differenz (DU) oder der Betrag der Differenz (DU) mit einem ersten Schwellwert (SW1) verglichen und bei dessen Überschreitung ein Störlichtbogenerkennungssignal (SLES) abgegeben oder andererseits wird die Differenz (DU) mit einem zweiten Schwellwert (SW2) verglichen und bei dessen Unterschreitung ein Störlichtbogenerkennungssignal (SLES) abgegeben.

FIG 3

EP 3 252 900 A1

**Beschreibung**

Die Erfindung betrifft eine Störlichtbogenerkennungseinheit, einen Leistungsschalter, einen Kurzschließer und ein Verfahren zur Störlichtbogenerkennung.

In Niederspannungsstromkreisen bzw. Niederspannungsanlagen respektive Niederspannungsnetzen, d.h. Stromkreise für Spannungen bis 1000 Volt Wechselspannung oder 1500 Volt Gleichspannung, sind Kurzschlüsse meist mit auftretenden Störlichtbögen, wie parallele oder serielle Störlichtbögen, verbunden. Besonders in leistungsstarken Verteil- und Schaltanlagen können diese bei einer nicht ausreichend schnellen Abschaltung zu verheerenden Zerstörungen von Betriebsmitteln, Anlagenteilen oder kompletten Schaltanlagen führen. Um einen länger andauernden und großflächigen Ausfall der Energieversorgung zu vermeiden und Personenschäden zu reduzieren, ist es erforderlich derartige Störlichtbögen, insbesondere stromstarke bzw. parallele Störlichtbögen, in wenigen Millisekunden zu erkennen und zu löschen. Konventionelle Schutzsysteme von Energieversorgungsanlagen (z.B. Sicherungen und Leistungsschalter) können unter den geforderten zeitlichen Anforderungen keinen zuverlässigen Schutz bieten.

Mit Leistungsschalter sind hier insbesondere Schalter für Niederspannung gemeint. Leistungsschalter werden, insbesondere in Niederspannungsanlagen, üblicherweise für Ströme von 63 bis 6300 Ampere eingesetzt. Spezieller werden geschlossene Leistungsschalter, wie Moulded Case Circuit Breaker, für Ströme von 63 bis 1600 Ampere, insbesondere von 125 bis 630 oder 1200 Ampere eingesetzt. Offene Leistungsschalter bzw. Luftleistungsschalter, wie Air Circuit Breaker, werden insbesondere für Ströme von 630 bis 6300 Ampere, spezieller von 1200 bis 6300 Ampere eingesetzt.

Leistungsschalter im Sinne der Erfindung können insbesondere eine elektronischen Auslöseeinheit, auch als Electronic Trip Unit, kurz ETU, bezeichnet, aufweisen.

Leistungsschalter überwachen den durch sie hindurchfließenden Strom und unterbrechen den elektrischen Strom bzw. Energiefluss zu einer Energiesenke bzw. einem Verbraucher, was als Auslösung bezeichnet wird, wenn Stromgrenzwerte oder Strom-Zeitspannengrenzwerte, d.h. wenn ein Stromwert für eine gewisse Zeitspanne vorliegt, überschritten werden. Die Ermittlung von Auslösebedingungen und das Auslösen eines Leistungsschalters kann mittels einer elektronischen Auslöseeinheit erfolgen.

Kurzschließer sind spezielle Einrichtungen zum Kurzschließen von Leitungen bzw. Stromschienen, um definierte Kurzschlüsse zum Schutz von Stromkreisen bzw. Anlagen herzustellen.

Konventionelle Störlichtbogendetektionssysteme werten die durch den Lichtbogen erzeugte Lichtemission aus und detektieren hiermit den Störlichtbogen.

Dies hat den Nachteil, dass parallel zu den elektrischen Leitungen bzw. Stromschienen Lichtwellenleiter bzw. optische Detektionssysteme verlegt werden müssen, um eventuell auftretende Störlichtbögen zu erkennen.

Aufgabe der vorliegenden Erfindung ist es, eine Möglichkeit zur Störlichtbogenerkennung aufzuzeigen.

Diese Aufgabe wird durch eine Störlichtbogenerkennungseinheit mit den Merkmalen des Patentanspruchs 1, einen Leistungsschalter gemäß Patentanspruch 11, einen Kurzschließer gemäß Patentanspruch 12 und ein Verfahren mit den Merkmalen des Patentspruchs 13 gelöst.

Erfindungsgemäß ist vorgesehen, dass eine Störlichtbogenerkennungseinheit für einen elektrischen Niederspannungsstromkreis mindestens einen Spannungssensor, zur periodischen Ermittlung von elektrischen Spannungswerten (u(k)) des elektrischen Stromkreises, und eine damit verbundene Auswerteeinheit aufweist. Diese ist derart ausgestaltet, dass fortlaufend eine erste Hälfte einer ersten Anzahl Spanungswerte (u(k)) zu einer ersten Teilsumme (TS1) und die zweite Hälfte an Spannungswerten (u(k)) zu einer zweiten Teilsumme (TS2) aufsummiert wird. Eine Differenz (DU) beider Teilsummen wird ermittelt. Entweder wird einerseits die Differenz (DU) oder der Betrag der Differenz (DU) mit einem ersten Schwellwert (SW1) verglichen. Bei wird dessen Überschreitung ein Störlichtbogenerkennungssignal (SLES) abgegeben.

Oder es wird andererseits die Differenz (DU) mit einem zweiten Schwellwert (SW2) verglichen und bei dessen Unterschreitung ein Störlichtbogenerkennungssignal (SLES) abgegeben. Alternativ kann auch ein paralleler Vergleich hinsichtlich zweier Schwellwerte erfolgen, bei dessen Über- bzw. Unterschreitung wird ein Störlichtbogenerkennungssignal abgegeben.

Die Beträge des ersten und des zweiten Schwellwertes können dabei identisch sein, wobei sich das Vorzeichen unterscheidet.

Vorteilhafte Ausgestaltungen der Erfindung sind in den Unteransprüchen angegeben.

In einer vorteilhaften Ausgestaltung der Erfindung ist der Niederspannungsstromkreis ein Wechselstromkreis. Dies hat den besonderen Vorteil, dass hier die Erfindung besonders wirkungsvoll eingesetzt werden kann.

In einer vorteilhaften Ausgestaltung der Erfindung ist die Störlichtbogenerkennungseinheit derart ausgestaltet, dass die Spannungswerte (u(k)) mit einem Vielfachen der Frequenz des Niederspannungsstromkreises ermittelt werden oder mit einer Abtastfrequenz im Bereich von 2-100 kHz, insbesondere im Bereich 10 bis 40 oder 60 kHz, spezifischer bei 40-50 kHz.

Dies hat den besonderen Vorteil, dass eine optimale Anzahl an Spannungswerten für die erfindungsgemäße Auswertung vorliegt. Bei einer Netzfrequenz des Niederspannungsstromkreises von 50 oder 60 Hz liegen so ca. 1000 Spannungswerte pro Grundwelle der Netzfrequenz vor. Bei dieser Anzahl hat sich eine gute Erkennung von Störlichtbögen mit der Erfindung gezeigt.

In einer vorteilhaften Ausgestaltung der Erfindung ist die Auswerteeinheit derart ausgestaltet, dass die erste Anzahl durch ein Zeitfenster bestimmt ist. D.h. die Anzahl an aufzusummierenden Stromwerten wird durch ein zu verwendendes Zeitfenster bestimmt. Aus dem Zeitfenster, dass beispielsweise im Bereich von 0,1 bis 5 ms oder 10 ms liegen kann, insbesondere bei 1 ms liegen kann, ergibt sich ferner durch die verwendete Abtastfrequenz die erste Anzahl an Spannungswerten.

Dies hat den besonderen Vorteil, dass die Auswertung ausschnittsweise erfolgt und so eine besonders genaue Erkennung von Störlichtbögen ermöglicht wird.

In einer vorteilhaften Ausgestaltung der Erfindung ist die Auswerteeinheit derart ausgestaltet, dass für jeden ermittelten Spannungswert (u(k)) eine Differenzermittlung durchgeführt wird. D.h. die erfindungsgemäße Differenzermittlung wird fortlaufend für jeden neuen Spannungswert durchgeführt. Dies hat den besonderen Vorteil, dass eine besonders zeitnahe und schnelle Ermittlung von Störlichtbögen ermöglicht wird.

In einer vorteilhaften Ausgestaltung der Erfindung ist die Auswerteeinheit derart ausgestaltet, dass die Differenz (DU) mit einem Faktor multipliziert wird, dessen Größe von der ersten Anzahl abhängig ist. Insbesondere ist der Faktor ein Produkt aus einer Konstanten und dem Kehrwert der ersten Anzahl.

Dies hat den besonderen Vorteil, dass eine normierte Differenz (DU) zur Verfügung steht, die mit normierten Schwellwerten verglichen wird. Somit wird eine Auswertung mit objektivem Vergleich ermöglicht.

In einer vorteilhaften Ausgestaltung der Erfindung ist die Auswerteeinheit derart ausgestaltet, dass fortlaufend eine zweite Anzahl Differenzen (DU) zu einer Differenzensumme (DS) aufsummiert wird, an Stelle der Differenz (DU) die Differenzsumme (DS) mit dem ersten oder zweiten Schwellwert (SW1, SW2) verglichen wird und bei dessen Über- bzw. Unterschreitung ein Störlichtbogenerkennungssignal (SLES) abgegeben wird.

Dies hat den besonderen Vorteil, dass eine noch genauere Ermittlung von Störlichtbögen ermöglicht wird, da sich die Differenzen, die bei Störlichtbögen auftreten, summieren. Damit steht ein genauerer bzw. größerer Wert für den Schwellwertvergleich zur Verfügung.

In einer vorteilhaften Ausgestaltung der Erfindung ist ferner mindestens ein Stromsensor vorgesehen ist, der periodisch elektrische Stromwerte des Stromkreises ermittelt. Dieser ist mit der Auswerteeinheit verbunden, die derart ausgestaltet ist, dass fortlaufend der ermittelte Stromwert mit einem dritten Schwellwert (SW3) verglichen wird und erst bei dessen Überschreitung ein Störlichtbogenerkennungssignal (SLES) abgegeben wird.

Dies hat den besonderen Vorteil, dass ein weiteres Kriterium für das Vorliegen von Störlichtbogen vorliegt und so die fehlerhafte Abgabe eines Störlichtbogenerkennungssignals vermieden wird. Störlichtbögen treten häufig erst bei höheren Strömen auf. Dies wird erfindungsgemäß bei der Auswertung berücksichtigt.

Erfindungsgemäß ist ferner ein Leistungsschalter für einen elektrischen Niederspannungsstromkreis vorgesehen. Dieser weist eine erfindungsgemäße Störlichtbogenerkennungseinheit auf. Diese ist mit dem Leistungsschalter verbunden, wobei diese derart ausgestaltet sind, dass bei Abgabe eines Störlichtbogenerkennungssignals der Leistungsschalter auslöst, d.h. den elektrischen Stromkreis unterbricht. Somit kann eine Löschung des Störlichtbogens erreicht werden. Weist der Leistungsschalter eine elektronische Auslöseeinheit auf, kann eine sehr schnelle Auslösung des Leistungsschalters bei vorliegen eines Störlichtbogenerkennungssignals erreicht werden. Dies hat den besonderen Vorteil, dass ein Leistungsschalter um eine weitere, vorteilhafte Funktionalität zum Schutz elektrischer Anlagen erweitert wird. Die Erkennung und Abschaltung von Störlichtbögen erfolgt dabei vorteilhaft in einem Gerät. Gegebenenfalls lassen sich vorhandene Baugruppen, wie Spannungs- oder/und Stromsensoren, Netzteil, Mikroprozessoren für die Auswerteeinheit, etc. mitverwenden und so Synergien erzielen.

Erfindungsgemäß ist ferner ein Kurzschließer, aufweisend eine Störlichtbogenerkennungseinheit die mit dem Kurzschließer verbunden ist, vorgesehen. Diese sind derart ausgestaltet, dass bei Abgabe eines Störlichtbogenerkennungssignals der Kurzschließer den elektrischen Stromkreis kurzschließt, um ein Löschen des Störlichtbogens zu bewirken.

Dies hat den besonderen Vorteil, dass eine einfache, schnelle und wirksame Möglichkeit zum Löschen von Störlichtbögen zur Verfügung steht.

Erfindungsgemäß ist des Weiteren ein Verfahren zur Störlichtbogenerkennung für einen elektrischen Stromkreis vorgesehen. Hierbei werden periodisch elektrische Spannungswerten (u(k)) des elektrischen Stromkreises ermittelt. Fortlaufend wird eine erste Hälfte einer ersten Anzahl Spanungswerte (u(k)) zu einer ersten Teilsumme (TS1) und die zweite Hälfte an Spannungswerten (u(k)) zu einer zweiten Teilsumme (TS2) aufsummiert. Eine Differenz (DU) beider Teilsummen wird ermittelt. Entweder wird einerseits die Differenz (DU) oder der Betrag der Differenz (DU) mit einem ersten Schwellwert (SW1) verglichen und bei dessen Überschreitung ein Störlichtbogenerkennungssignal (SLES) abgegeben.

Oder es wird andererseits die Differenz (DU) mit einem zweiten Schwellwert (SW2) verglichen und bei dessen Unterschreitung ein Störlichtbogenerkennungssignal (SLES) abgegeben. Alternativ kann die Differenz auch mit dem ersten und dem zweiten Schwellwert verglichen werden und bei einer Über- bzw. Unterschreitung ein Störlichtbogenerkennungssignal (SLES) abgegeben werden. Hierbei können die Beträge des ersten und zweiten Schwellwertes identisch sein.

Dies hat den besonderen Vorteil eines einfachen Verfahrens zur Störlichtbogenerkennung.

Alle Ausgestaltungen und Merkmale der Erfindung bewirken eine Verbesserung der Erkennung von Störlichtbögen bzw. deren Löschung.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Hierbei zeigt:

Figur 1 ein Diagramm des zeitlichen Spannungs- und Stromverlaufes nach Lichtbogenzündung

Figur 2 ein Ersatzschaltbild eines elektrischen Stromkreises

Figur 3 ein erste Ablaufdiagramm zur Störlichtbogenerkennung

Figur 4 ein Blockschaltbild einer erfindungsgemäßen Lösung

Figur 5 eine erste Darstellung zur Erläuterung des Einsatzes der Erfindung

Figur 6 eine zweite Darstellung zur Erläuterung des Einsatzes der Erfindung

Figur 7 eine dritte Darstellung zur Erläuterung des Einsatzes der Erfindung

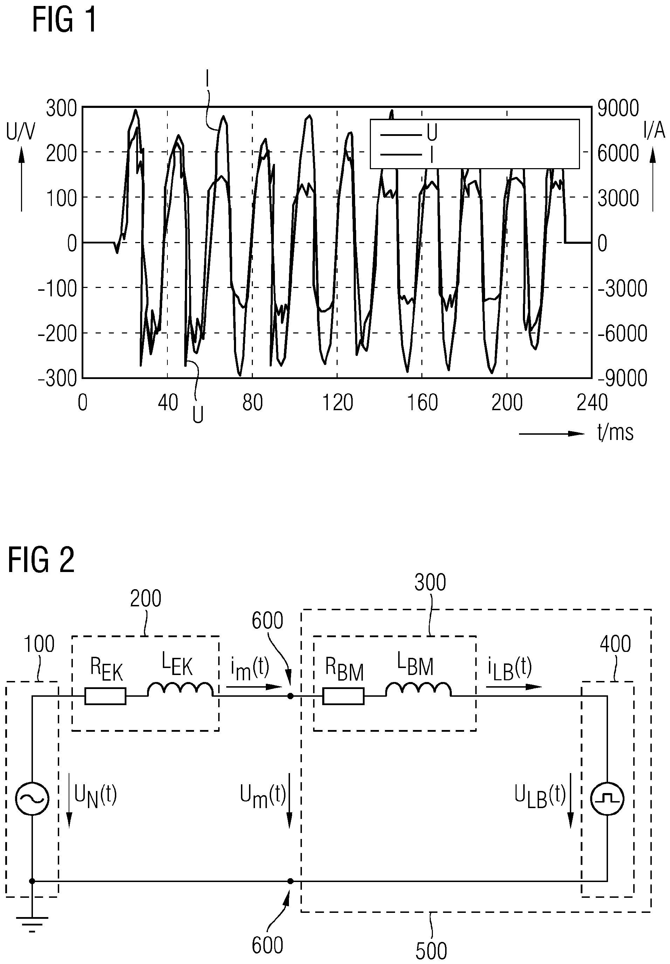

In einem Stromkreis bzw. Netz, in dem ein Störlichtbogen brennt, kann ein Strom- und Spannungsverlauf gemessen werden, der einen signifikanten Verlauf aufweist. Ein typischer Spannungs- und Stromverlauf für einen Störlichtbogen ist in Figur 1 dargestellt. Diese zeigt eine Darstellung eines Diagramms, in dem der zeitliche Verlauf der elektrischen Spannung U und des elektrischen Stromes I nach Zündung eines Lichtbogens bzw. Störlichtbogens, insbesondere parallelen Störlichtbogen, in einem elektrischen Stromkreis, insbesondere Niederspannungsstromkreis, dargestellt ist.

Auf der horizontalen X-Achse ist die Zeit t in Millisekunden (ms) dargestellt. Auf der vertikalen Y-Achse ist auf der linken Skalierung die Größe der elektrischen Spannung U in Volt (V) abgebildet. Auf der rechten Skalierung ist die Größe des elektrischen Stromes I in Ampere (A) abgebildet.

Nach Lichtbogenzündung verläuft der Strom I annähernd sinusförmig. Die Spannung U verläuft stark verzerrt, etwa "zackenförmig", mit schnellen Spannungsänderungen. Grob interpretiert ist der Spannungsverlauf in erster Näherung rechteckförmig, an Stelle eines üblicherweise sinusförmigen Verlaufs. Abstrahiert betrachtet, lässt sich im Spannungsverlauf eine Rechteckform erkennen, die auf dem Plateau einen hoch stochastischen Anteil aufzeigt. Die Rechteckform ist dadurch gekennzeichnet, dass es bei der Lichtbogenzündung und in den nachfolgenden Spannungsnulldurchgängen der Wechselspannung zu signifikant erhöhten Spannungsänderungen kommt, die folgend als Spannungssprung bezeichnet werden, da der Anstieg der Spannungsänderung im Vergleich zu einem sinusförmigen Spannungsverlauf wesentlich größer ist.

Erfindungsgemäß sollen derartige Spannungsänderungen bzw. Spannungssprünge erkannt werden und daraufhin ein Störlichtbogenerkennungssignal abgegeben werden.

Hierzu werden periodisch, mit beispielsweise einer festen Abtastzeit bzw. Abtastfrequenz fa Spannungswerte eines elektrischen Stromkreises ermittelt, erfasst bzw. gemessen. Dabei sollte die Abtastfrequenz bzw. Meßfrequenz ein Vielfaches der Frequenz der gemessenen Wechselgrößen betragen. Beispielsweise könnte bei üblichen Stromnetzen, mit beispielsweise 50Hz bzw. 60Hz Netzfrequenz, die Meßfrequenz im Kilohertz-Bereich liegen, beispielsweise zwischen 1 und 200 kHz, spezifischer im Bereich 10 bis 40 oder 60 kHz, insbesondere bei 40-50 kHz.

Mit Hilfe dieser Spannungswerte soll erfindungsgemäß ein Störlichtbogenerkennungssignal ermittelt werden.

Erfindungsgemäß soll der Spannungssprung bei der Lichtbogenzündung und in jedem darauf folgenden Spannungsnulldurchgang erkannt werden und daraufhin ein Störlichtbogen detektiert werden. Ein wesentlicher Vorteil bei der Extraktion dieser Signaleigenschaft im Spannungsverlauf ist das periodische Auftreten. Somit kann eine zusätzliche Detektionssicherheit erreicht werden, wenn gewollt oder ungewollt das erste Auftreten der Signaleigenschaft bei der Lichtbogenzündung nicht zu einer Detektion des Störlichtbogens führt.

Für die Extraktion dieser Signaleigenschaft soll erfindungsgemäß eine Summation mit Differenzberechnung verwendet werden, die als W-RU und in einer Ausgestaltung als W-RUs Verfahren bezeichnet werden soll.

Die Auswertung erfolgt dahingehend, dass eine Differenz bzw. ein Spannungssprung DU eingeführt wird.

Dieser wird wie folgt ermittelt:

$$DU(n) = \sum_{k=n-(j-1)}^{k=n-\frac{j}{2}} u(k) \ - \ \sum_{k=n-(\frac{j}{2}-1)}^{k=n} u(k) \tag{1}$$

wobei:

u (k)   Spannungswert zum (zurückliegenden) Zeitpunkt k
u (n)   Spannungswert zum aktuellen Zeitpunkt n
DU (n)   Differenz zum aktuellen Zeitpunkt n
j   erste Anzahl, d.h. Anzahl an Zeitpunkten bzw. Abtastwerten die für die Berechnung der Differenz verwendet werden

Mit der obigen Formel wird für einen aktuell gemessenen Spannungswert u(n) die Differenz DU(n) ermittelt. Als Basis für die Berechnung dient die erste Anzahl j, die beispielsweise eine feste Zahl sein kann. Beispielsweise wird eine feste Zahl j an Abtastwerten für jede Berechnung verwendet. Beispielsweise kann j im Bereich 10 bis 100 liegen, insbesondere im Bereich 40-50.

Für den Fall j=40 soll die Berechnung dargestellt werden. Verwendet wird hierzu der aktuell gemessene Spannungswert u(n) und die davorliegenden respektive zurückliegenden bzw. vergangenen 39 Spannungswerte u(n-1) bis u(n-(40-1)), d.h.
u(n-1) bis u(n-40+1), d.h.
u(n-1) bis u(39).
In Summe (j=)40 Spannungswerte.

Für die erste Teilsumme (TS1) werden die Spannungswerte u(k) für

$$k \ = \ n-(j-1) \ = \ n-(40-1) \ = \ n-39$$

bis

$$k \ = \ n-j/2 \ = \ n-40/2 \ = \ n-20$$

aufsummiert, also vom zurückliegenden (älteren) 39sten Spannungswert bis zum zurückliegenden (jüngeren) 20sten Spannungswert, in Summe 20 Werte.

Als zweite Teilsumme (TS2) werden die Spannungswerte u(k) für

$$k \ = \ n-(j/2-1) \ = \ n-(40/2-1) \ = \ n-19$$

bis

$$k \ = \ n$$

aufsummiert, also vom zurückliegenden 19ten Spannungswert bis zum aktuellen Spannungswert u(n), in Summe ebenfalls 20 Spannungswerte.

Die Differenz DU beider Teilsummen wird mit einem, von der Anzahl j abhängigen, ersten Schwellwert SW1 verglichen. Bei dessen Überschreitung wird ein Störlichtbogenerkennungssignal abgegeben.

Hierbei werden jeweils die Hälften der ersten Anzahl j aufsummiert. Mit Hälfte im Sinne der Erfindung ist auch ein um einen Wert abweichender halber Wert gemeint. D.h. Es könnten gemäß einer ersten Variante in der ersten Teilsumme 19 Werte und in der zweiten Teilsumme 21 Werte aufsummiert werden. wobei j den Wert 40 hat.
In einer zweiten Variante ist bei einer ungeraden ersten Anzahl j eine unsymmetrische Aufteilung gemeint. D.h. es können in einer ersten Teilsumme beispielsweise 19 Werte aufsummiert und in der zweiten Teilsumme 20 Werte aufsummiert werden, wobei j in diesen Fall den Wert 39 hätte.

Als Teilsummen können auch Mittelwerte verwendet werden, die aus den jeweiligen Spannungswerten ermittelt werden, beispielsweise durch Teilsummen. D.h. es könnte auch ein Mittelwert aus einer stark abweichenden Anzahl an Spannungswerten, beispielsweise pro Teilsumme, gebildet werden.

Alternativ können beide Teilsummen bzw. die Differenz mit einem Faktor, der beispielsweise den Kehrwert der ersten Anzahl j enthält, multipliziert werden, also beispielsweise mit 1/j oder 2/j.

$$DU(n) = \frac{2}{j}\left[\sum_{k=n-j+1}^{k=n-\frac{j}{2}} u(k) \ - \sum_{k=n-\frac{j}{2}+1}^{k=n} u(k)\right] \tag{2}$$

Dadurch ist ein Vergleich mit einem von der Anzahl der verwendeten Abtastwerte, d.h. von der ersten Anzahl j unabhängigen ersten Schwellwert SW1 möglich, da die Differenz normiert auf die im Stromkreis verwendete Spannung, d.h. dem äquivalent stattfinden Spannungssprung entspricht.

Der Wert der Differenz ist somit nicht mehr von der Anzahl der Summierungen abhängig, allerdings von der verwendeten Spannung.

Man kann gemäß der ersten oder zweiten Variante die Hälfte in eine erste Teilsummenanzahl g und h aufteilen, wobei j=g+h und g≠h.

$$DU(n) = \frac{1}{g}\sum_{k=n-(g+h)+1}^{k=n-h} u(k) \ - \frac{1}{h}\sum_{k=n-h+1}^{k=n} u(k) \tag{3}$$

Die erste Anzahl j respektive Anzahl verwendeter Abtastwerte j bestimmt über die verwendete Abtastfrequenz den verwendeten Zeitrahmen.

Umgekehrt kann bei vorgegebener Abtastfrequenz und zu überprüfenden Zeitfenster die zu verwendende erste Anzahl ermittelt werden.

Die drei Größen Zeitfenster ta, Abtastfrequenz fa und Anzahl Abtastwerte (=erste Anzahl) j sind jeweilig in einander überführbar, j = ta · fa.

Bei Netzfrequenz des Niederspannungsstromkreises von 50-60Hz hat sich eine Abtastfrequenz von 1 bis 200 kHz, insbesondere 1 bis 60 kHz, spezifischer 40 - 50 kHz, und ein Zeitfenster bzw. eine Dilatationszeit von 0,1 ms bis 5 ms oder 10 ms, insbesondere bei etwa 1 ms, für eine sichere Detektion von Störlichtbögen ergeben. Somit ergibt sich für die erste Anzahl j der benötigten Abtastwerte bzw. Abtastpunkte j = 40 - 50.

Mit Dilatationszeit ist die Ausdehnung des Zeitfensters gemeint, über den man die Teilsummen bzw. den äquivalenten Spannungssprung berechnet.

Die beiden Teilsummen TS1 und TS2 können auch vertauscht sein. D.h. die erste Teilsumme wird von der zweiten Teilsumme abgezogen. Dadurch ändert sich lediglich das Vorzeichen. Beispielsweise kann in analoger Weise bei Wechselstromnetzen nach einem Flankenwechsel, d.h. wenn von einer steigenden Flanke auf eine fallende Flanke der üblicherweise sinusförmigen Wechselspannungen gewechselt wird, ebenfalls ein Vorzeichenwechsel auftreten.

Eine steigende Flanke tritt bei sinusförmigen Spannungen üblicherweise im Bereich 0° bis 90° und 270° bis 360° auf, eine fallende Flanke üblicherweise im Bereich 90° bis 270°.

Falls nicht der Betrag der Differenz DU, sondern der Absolutwert mit dem ersten oder zweiten Schwellwert verglichen wird, ist gegebenenfalls eine Anpassung des Vorzeichens erforderlich.

Wesentlich ist, dass zumindest inhaltlich mindestens ein Betrag der Differenz DU mit mindestens einem Betrag des ersten oder zweiten Schwellwertes SW1, SW2 verglichen wird. Bei dessen betragsmäßiger Überschreitung wird ein Störlichtbogenerkennungssignal SLES abgegeben. Optimalerweise kann der Betrag der Differenz mit dem ersten Schwellwert SW1 verglichen werden, um eine besonders gute Störlichtbogenerkennung zu erreichen.

Allgemein kann die ermittelte Differenz auch mit zwei Schwellwerten SW1, SW2 verglichen werden, wobei der erste Schwellwert SW1 positiv ist und bei dessen Überschreitung, analog zum Betrag der Differenz, ein Störlichtbogenerkennungssignal SLES abgegeben wird, und der zweite Schwellwert SW2 negativ ist (für negative Differenzen) und bei dessen Unterschreitung ein Störlichtbogenerkennungssignal SLES abgegeben wird.

Für eine sichere Detektion eines Störlichtbogens ist es notwendig den Betriebsfall - Anlage ohne Störlichtbogen - vom Fehlerfall - Anlage mit Störlichtbogen - abzugrenzen. Mit einem Schwellwertvergleich wird die Unterscheidung zwischen den Zuständen: a) Störlichtbogen vorhanden und b) Kein Störlichtbogen vorhanden, getroffen.

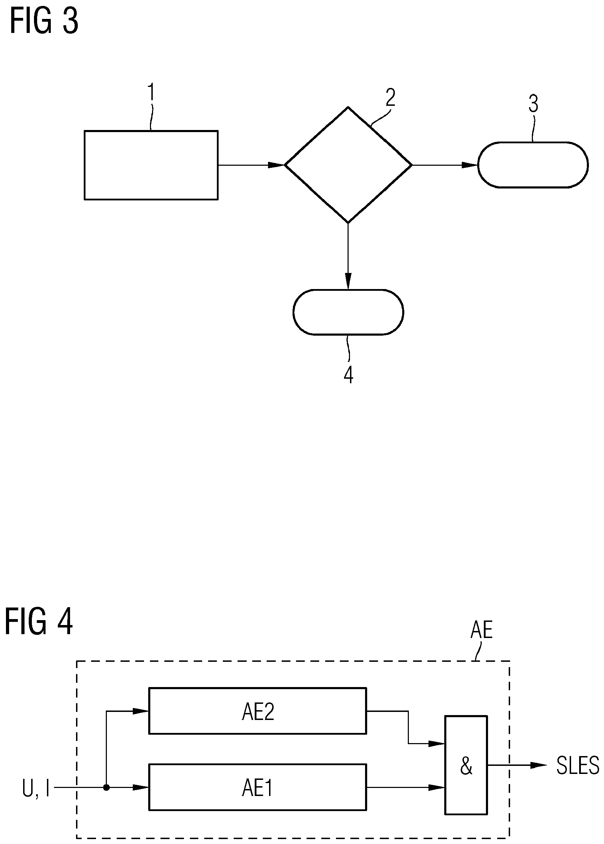

In Figur 3 ist ein derartiges Diagramm dargestellt. In einem ersten Schritt 1 erfolgt die fortlaufende erfindungsgemäße Berechnung der Differenz DU.

In einem zweiten Schritt 2 wird diese jeweils mit dem ersten Schwellwert SW1 bzw. zweiten Schwellwert SW2 verglichen.

Erfolgt eine Überschreitung des ersten Schwellwertes SW1 bzw. Unterschreitung des zweiten Schwellwertes SW2, wird in einem dritten Schritt 3 die Erkennung eines Störlichtbogens angezeigt und/oder ein Störlichtbogenerkennungssignals abgegeben. Ist der erste Schwellwert SW1 nicht überschritten bzw. zweite nicht unterschritten, kann in einem vierten Schritt 4 die Meldung, dass kein Störlichtbogen vorhanden ist, erfolgen.

Beispielsweise kann der erste Schwellwert SW1 im Falle einer normierten Berechnung im Bereich 8 Volt bis 300 Volt liegen, insbesondere 10 bis 30 oder 100 Volt, spezifischer im Bereich 15 bis 20 oder 25 Volt.

Dabei sei darauf verwiesen, dass die berechnete Differenz DU bzw. äquivalente Spannungssprung unter dem realen, im Spannungsverlauf erkennbaren, Spannungssprung liegt.

Eine weitere Verbesserung lässt sich durch eine weitere Aufsummierung der Differenzen DU zu einer Differenzsumme DS erreichen. Dies wird im Folgenden auch als W-RUs Verfahren bezeichnet. Bei Störlichtbögen, die keinen großen Spannungssprung erzeugen, kann so eine schnellere Detektion erreicht werden.

Bei dem W-RUs-Verfahren werden einzelne Differenzen bzw. Spannungssprünge, die besonders bei der Lichtbogenzündung in Folge von mehreren kleinen, nacheinander zündenden Lichtbögen auftreten, addiert.

Die ermittelten Differenzen DU werden mit einer zweiten Anzahl z, die im Bereich der ersten Anzahl j liegen aber auch größer oder kleiner sein kann, zu einer Differenzensumme DS aufsummiert. Beispielsweise kann die zweite Anzahl z den einbis vier- bis sechsfachen Wert von j aufweisen.

$$DS(n) = \sum_{k=n-z}^{k=n} DU(k) \qquad (4)$$

z       zweite Anzahl, d.h. Anzahl an Differenzen DU, die für die Berechnung der Differenzensumme verwendet werden

DS (n)       Differenzensumme, bezogen auf den aktuellen Wert n

Die zweite Anzahl z kann hierbei wieder über die Abtastfrequenz fa und das für die Summation zu betrachtende Zeitfenster ts bestimmt werden, z = ts · fa.

Bei Verwendung der Summation kann bzw. sollte das erste Zeitfenster bzw. die erste Dilatationszeit ta zur Berechnung des einzelnen Spannungssprungs geeignet gewählt werden, beispielsweise kleiner gewählt werden. Die Zeit ta könnte hierbei etwa 0,05 bis 1 ms betragen, insbesondere bei 0,2 ms liegen.

Ferner hat sich als vorteilhaft herausgestellt, wenn die für die Summation verwendeten Differenzen nicht ein zweites Mal für die darauffolgende Summation verwendet werden.

Für eine einfache, programmmäßige Umsetzung des Algorithmus, kann beispielsweise für jeden Spannungswert u(n) bzw. Abtastpunkt ein relativer, äquivalenter Spannungssprung bzw. Abtastdifferenz DA(n) pro Spannungswert u(n) bezogen auf die erste Anzahl j bzw. Größe des Dilatationsparameters wie folgt berechnet werden:

$$DA(n) = \frac{DU(n)}{j} \qquad (5)$$

D.h. die Differenz DU wird durch die erste Anzahl j geteilt, um die Abtastdifferenz für einen Spannungswert u(n) zu erhalten. Die berechnete Abtastdifferenz DA(n) beschreibt den relativen, äquivalenten Spannungssprung pro Spannungswert u(n) bzw. Abtastwert. Es wird eine Art Normierung durchgeführt.

Beispielsweise wird ein erster Spannungswert u(1) von 36 Volt, ein nachfolgender zweiter Spannungswert u(2) von 40 Volt, ein nachfolgender dritter Spannungswert u(3) von 50 Volt, ein nachfolgender vierter Spannungswert u(4) von 60 Volt, ein nachfolgender fünfter Spannungswert u(5) von 70 Volt, ein nachfolgender sechster Spannungswert u(6) von 72 Volt, ein nachfolgender siebter Spannungswert u(7) von 74 Volt gemessen.

Beispielsweise hat die erste Anzahl j einen Wert von 4.

Gemäß Formel 2 beträgt die erste Teilsumme 76 Volt, die zweite Teilsumme 110 Volt. Die reine Differenz der Teilsummen beträgt 34 Volt, multipliziert mit 2/j, d.h. 2/4, beträgt die Differenz DU(4) 17 Volt. D.h. die Differenz entspricht einem gemittelten Spannungssprung über die 4 Spannungswerte von 17 Volt.

Bezogen auf die ersten vier Spannungswerte u(1), ..., u(4) bzw. Abtastwerte beträgt die Abtastdifferenz DA(4): 17 Volt durch 4 gleich 4,25 Volt (d.h. der relative Spannungssprung pro Spannungswert).

Bezogen auf die nächsten vier Spannungswerte u(2),..., u(5) beträgt die Differenz der Teilsummen 130 Volt - 90 Volt = 40 Volt. Die Differenz DU(5) dann wieder 20 Volt. Die Abtastdifferenz DA(5) 5 Volt (d.h. der relative Spannungssprung pro Spannungswert).

Bezogen auf die nächsten vier Spannungswerte u(3),..., u(6) beträgt die Differenz der Teilsummen 142 Volt - 110 Volt = 32 Volt, die Differenz DU(6) dann 16 Volt, die Abtastdifferenz DA(6) 4 Volt (d.h. der relative Spannungssprung pro Spannungswert).

Bezogen auf die nächsten vier Spannungswerte u(4),..., u(7) beträgt die Differenz der Teilsummen 146 Volt - 130 Volt = 16 Volt, die Differenz DU(7) dann 8 Volt, die Abtastdifferenz DA(7) 2 Volt (d.h. der relative Spannungssprung pro Spannungswert).

In einer Ausgestaltung der Erfindung soll nun für jede (fortlaufend) berechnete Abtastdifferenz DA(n) der jeweils maximale Wert aufsummiert werden.

Dazu wird die Abtastdifferenz DA(n) jeweils den j Spannungswerten, die für die Berechnung der Differenz und Abtastdifferenz verwendet wurden, zugeordnet, siehe die nachfolgende Tabelle.

| n | U (n) | DA (1) | DA(2) | DA (3) | DA(4) | DA (5) | DA (6) | DA(7) | DAmax(n) |
|---|-------|--------|-------|--------|-------|--------|--------|-------|----------|
| 1 | 36 V | 4,5 V (0 V) | 9,5 V (0 V) | 6,75V (0 V) | 4,25V | | | | 4,25 V |
| 2 | 40 V | | 9,5 V (0 V) | 6,75V (0 V) | 4,25V | 5 V | | | 5 V |
| 3 | 50 V | | | 6,75V (0 V) | 4,25V | 5 V | 4 V | | 5 V |
| 4 | 60 V | | | | 4,25V | 5 V | 4 V | 2 V [0 V] | 5 V |
| 5 | 70 V | | | | | 5 V | 4 V | 2 V [0 V] | 5 V |
| 6 | 72 V | | | | | | 4 V | 2 V [0 V] | 4 V |
| 7 | 74 V | | | | | | | 2 V [0 V] | 2 V [0 V] |

Falls noch nicht die erste Anzahl j Spannungswerte u(n), u(k) für eine Berechnung vorliegen, können die Differenzen bzw. Abtastdifferenzen auf Null gesetzt werden, siehe die in Klammern angegeben Werte von 0 Volt in den Spalten DA(1), DA2, DA(3).

Aus den j zugeordneten Abtastdifferenzen pro Spannungswert U(n) wird jeweils die maximale Abtastdifferenz DAmax(n) ermittelt. Dabei liegen natürlich für die gerade zurückliegenden Abtastdifferenzen DA(n) nur weniger als j Abtastdifferenzen DA vor, wobei dann die aktuelle bzw. maximale Abtastdifferenz DA der vorliegenden Abtastdifferenzen verwendet wird.

Die maximalen Abtastdifferenzen DAmax pro Spannungswert U(n) werden zu einer Summe der maximalen Abtastdifferenzen SMA aufsummiert, und zwar jeweils eine zweite Anzahl z an maximalen Abtastdifferenzen SMA.

$$\mathrm{SMA(n)} \;=\; \sum_{k=n-z}^{k=n} DAmax\,(k) \qquad\qquad (6)$$

Hat die zweite Anzahl z beispielsweise einen Wert von z=6, ergibt sich ein Summe der maximalen Abtastdifferenzen für die ersten 6 maximalen Abtastdifferenzen von SMA(6) = 28,25 Volt.

Die Summe der maximalen Abtastdifferenzen SMA bzw. dessen Betrag wird mit dem ersten oder/und zweiten Schwellwert SW1, SW2 verglichen und bei dessen betragsmäßiger Überschreitung ein Störlichtbogenerkennungssignal SLES abgegeben.

Dies hat den Vorteil, dass mehrere in Folge auftretende Spannungssprünge aufsummiert werden und deren Summe für die Auswertung des Vorliegens eines Störlichtbogens verwendet werden.

In einer Ausgestaltung der Erfindung kann ein weiterer Schwellwertvergleich dahingehend vorgesehen sein, dass für die Berechnung der Abtastdifferenz DA(n) der Wert von DU(n) auf Null gesetzt wird, wenn dessen Betrag einen vierten Schwellwert SW4 unterschreitet.

Für ein Niederspannungsnetz kann dieser vierte Schwellwert SW4 im Bereich im Bereich 8 Volt bis 50 Volt liegen, insbesondere 10 bis 30, spezifischer im Bereich 10 bis 20 oder 25 Volt liegen.

Er kann auch identisch mit dem Betrag des ersten bzw. zweiten Schwellwertes sein bzw. in dessen Größenordnung liegen.

Dies hat den Vorteil, dass der typische - üblicherweise sinusförmige - Spannungsverlauf nicht bzw. weniger berücksichtigt wird.

Beispielsweise könnte gemäß Beispiel die siebte Differenz DU(7), die den Wert 8 Volt aufweist, betragsmäßig unter dem vierten Schwellwert SW4 liegen, der beispielsweise einen Betrag von 10 Volt aufweist. Damit würde die siebte Abtastdifferenz DA(7) den Wert 0 Volt aufweisen. Dies insbesondere in Spalte DA(7) durch Werte von 0 Volt in eckigen Klammern dargestellt.

Figur 2 zeigt ein Ersatzschaltbild eines elektrischen Stromkreises, aufweisend ein elektrische Energiequelle 100, die eine elektrische Netz-Spannung $u_n(t)$ zur Verfügung stellt, einen daran angeschlossenen Netzzugang bzw. ein Einspeise-Kabel 200, dargestellt durch elektrische Ersatzschaltelemente, wie einen Einspeise-Kabel-Widerstand $R_{ek}$

und eine Einspeise-Kabel-Induktivität bzw. Spule $L_{ek}$, dem ein elektrischer Verbraucher, Betriebsmittel bzw. Energiesenke 300 folgt, wiederum dargestellt durch elektrische Ersatzschaltelemente, wie einen Verbraucher-Widerstand $R_{BM}$ und eine Verbraucher-Induktivität bzw. Spule $L_{BM}$. Zwischen Einspeise-Kabel 200 und Verbraucher 300 kann eine elektrische Spannung $u_m(t)$ und eine elektrische Stromgröße, wie der elektrische Stromwert $i_m(t)$ oder/und die Änderung des Stromes nach der Zeit $i'_m(t)$, respektive die erste Ableitung des Stromes nach der Zeit, gemessen werden. Diese Größen, insbesondere die elektrische Spannung bzw. elektrischen Spannungswerte, werden an den Meßpunkten 600 erfasst, um in der Störlichtbogenerkennungseinheit weiter verarbeitet zu werden.

Der hinsichtlich Störlichtbogen überwachte Bereich ist durch eine gestrichelte Linie 500 dargestellt.

Im elektrischen Stromkreis kann ein Störlichtbogen auftreten, der durch einen Lichtbogen 400 mit einer Lichtbogenspannung $U_{lb}(t)$ dargestellt ist.

Die erfindungsgemäße Störlichtbogenerkennung kann mit weiteren Kriterien kombiniert werden. Beispiels mit einem weiteren Vergleich der Höhe des elektrischen Stromes des Stromkreises. Der gemessene Strom, insbesondere der Effektivwert des gemessenen Stromes, der beispielsweise nach der Methode von Mann-Morrison berechnet werden kann, wird dabei mit einem dritten Schwellwert SW3 verglichen und nur wenn auch dieser dritte Schwellwert SW3 überschritten ist und das Kriterium für ein Störlichtbogenerkennungssignal erfüllt ist, wird ein solches abgegeben.

Diese als Überstromfreigabe bezeichnetes Kriterium führt zu einer sicheren Fehlerabgrenzung. Für die Störlichtbogenerkennung muss ein minimaler Störlichtbogenstrom im Stromkreis fließen, um ein Störlichtbogenerkennungssignal zu bewirken. Als Schwellwert für die Überstromfreigabe kann ein vom Betriebsstrom abhängiger Wert gewählt werden. Alternativ könnte die Schwellwertfestlegung auch lichtbogenspezifisch erfolgen, da für einen brennenden parallelen Niederspannungslichtbogen ein Lichtbogenstrom von üblicherweise 1000 A notwendig ist. Ein serieller Lichtbogen ist bei wesentlich geringeren Strömen möglich. D.h. der dritte Schwellwert SW3 kann je nach Einsatz bzw. Anwendung jeden Wert ab 1 A, 10 A, 100 A, 1000 A oder 5000 A aufweisen.

Die Verknüpfung zwischen Überstromfreigabe und der erfindungsgemäßen Lichtbogenspannungsberechnung ist in Figur 4 dargestellt.

Figur 4 zeigt eine Darstellung, bei der die ermittelte Spannung U bzw. um(t) und die ermittelte Stromgröße des Stromkreises einer ersten Auswerteeinheit AE1, zur erfindungsgemäßen Ermittlung der Lichtbogenspannung zugeführt wird.

Die ermittelte Stromgröße des Stromkreises wird einer zweiten Auswerteeinheit AE2, zur Prüfung des Stromkriteriums - Überschreitung des dritten Schwellwertes SW3, zugeführt.

Die Ausgänge der beiden Auswerteeinheiten AE1, AE2 sind mit einer UND-Einheit & verknüpft, dessen Ausgang bei Erfüllung der Kriterien ein Störlichtbogenerkennungssignal SLES abgibt. Die beiden Auswerteeinheiten können dabei als Teileinheiten bzw. Untereinheiten in einer Auswerteeinheit AE angeordnet sein.

Des Weiteren kann die Abgabe eines Störlichtbogenerkennungssignals erst dann erfolgen, wenn mindestens zweimal die Differenz bzw. Differenzensumme oder/und das Stromkriterium den entsprechenden Schwellwert überschreitet. Analog kann auch eine dreimalige, viermalige, fünfmalige, usw. Überschreitung des Schwellwertes zur Abgabe eines Störlichtbogenerkennungssignales führen. So wird eine besonders sichere Auswertung und Erkennung eines Störlichtbogens erreicht.

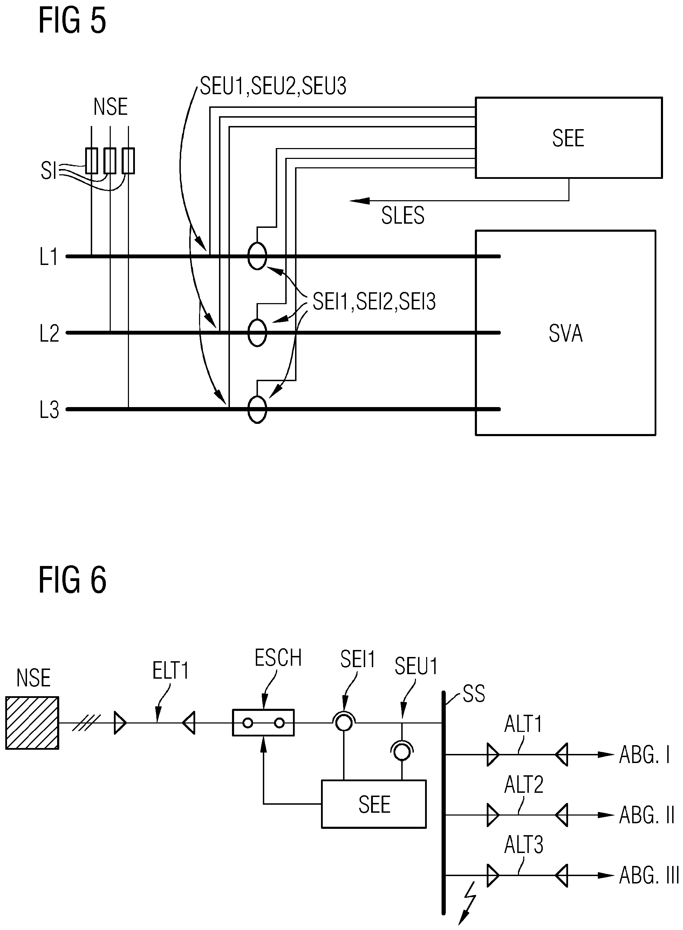

Figur 5 zeigt eine schematische Darstellung eines Übersichtsschaltbildes für eine Anlagenkonfiguration mit abgangsselektiver Störlichtbogenerkennungseinheit für die Erfassung von Störlichtbogen. Figur 5 zeigt eine NiederspannungsEinspeisung NSE, mit Sicherungen SI, denen Stromschienen bzw. Sammelschienen L1, L2, L3 für die Leiter eines Dreiphasen-Wechselstromnetzes bzw. Stromkreises folgen. Der Neutralleiter bzw. Nullleiter ist nicht dargestellt. Jeder der drei Stromschienen L1, L2, L3 ist jeweils ein Spannungssensor SEU1, SEU2, SEU3 und ein Stromsensor SEI1, SEI2, SEI3 zugeordnet. Die Stromschienen sind mit einer Schalt- oder/und Verteilanlage SVA verbunden.

Die Spannungs- und Stromsensoren sind mit einer erfindungsgemäßen Störlichtbogenerkennungseinheit SEE verbunden, die eine erfindungsgemäße Auswerteeinheit AE aufweist. Diese weist einen Ausgang zur Abgabe eines Störlichtbogenerkennungssignals SLES auf.

Die Spannungs- und Stromsensoren ermitteln Spannungswerte und Stromgrößen (Stromwert oder/und Stromwertänderung) der Sammelschienen L1, L2, L3 und führen sie der erfindungsgemäßen Störlichtbogenerkennungseinheit SEE zu.

Die Sensoren sind dabei außerhalb Störlichtbogenerkennungseinheit angeordnet und mit dieser verbunden.

Figur 6 zeigt eine weitere schematische Darstellung eines Übersichtsschaltbildes für eine Anlagenkonfiguration mit zentraler Störlichtbogenerkennungseinheit für die Erfassung von Störlichtbogen. Figur 6 zeigt eine Niederspannungseinspeisung NSE, der ein Einspeise-Kabel ELT1 folgt, dem ein Einspeise-Schalter ESCH folgt, dem ein Stromsensor SEI1 und ein Spannungssensor SEU1 folgt, dem eine Sammelschiene SS folgt. An der Sammelschiene SS sind 3 Abgänge ABG I ABG II und ABG III vorgesehen. Diesen ist je ein Abgangs-Kabel ALT1, ALT2, ALT3 zugeordnet.

Die Sensoren SEI1, SEU1 sind mit einer Störlichtbogenerkennungseinheit SEE verbunden, dessen Ausgang wiederum mit dem Einspeise-Schalter ESCH verbunden ist. Der Einspeise-Schalter kann dabei ein Leistungsschalter sein. Bei Erkennung eines Störlichtbogens kann der elektrische Stromkreis, d.h. die Stromversorgung der Sammelschiene SS unterbrochen werden, wenn beispielsweise in einem der Abgänge ein Störlichtbogen auftritt.

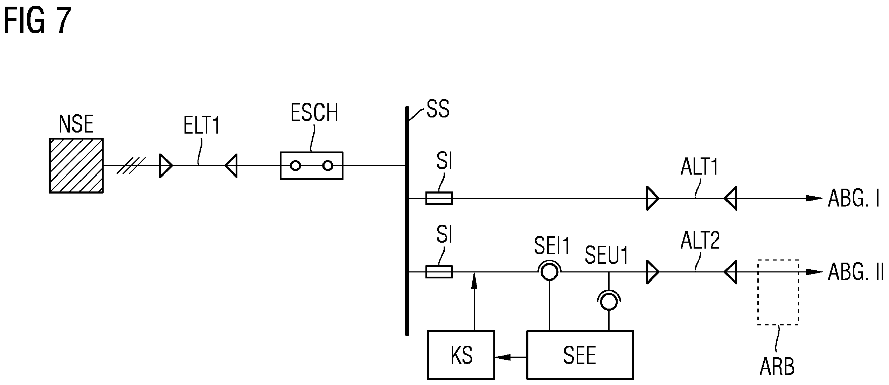

Figur 7 zeigt eine Darstellung gemäß Figur 6, mit dem Unterschied, dass die Sensoren im zweiten Abgang ABG II angeordnet sind, der zudem Sicherungen SI und einen Kurzschließer KS aufweist. Die Sensoren SEI1 und SEU1 erfassen Strom- und Spannungswerte des Abganges ABG II und geben diese an die Störlichtbogenerkennungseinheit SEE weiter. Erkennt die Störlichtbogenerkennungseinheit SEE einen Störlichtbogen, wird an ihrem Ausgang ein Störlichtbogenerkennungssignal abgegeben und zum Kurzschließer KS übertragen. Dieser schließt daraufhin den Abgang ABG II kurz, um den Störlichtbogen zu löschen.

Die Störlichtbogenerkennung gemäß Figur 6 oder 7 kann beispielsweise als mobiles System ausgeführt sein.

Die Erfindung soll im Folgenden nochmals erläutert werden.

Mit der Erfindung können Störlichtbögen, insbesondere parallele oder stromstarke, insbesondere in Niederspannungsschalt-und Verteilungsanlagen, erkannt werden. Erfindungsgemäß steht dazu insbesondere eine nummerischer Lösung bzw. Detektionsalgorithmus auf Grundlage der Auswertung von gemessenen Spannungs- bzw. Stromwerten bzw. -signalen zur Verfügung. Für die Erkennung von Störlichtbögen wird insbesondere die Spannung gemessen und Mithilfe einer erfindungsgemäßen Berechnung ein Störlichtbogen ermittelt. Aufgrund der in der Praxis notwendigen schnellen Lichtbogendetektion kann hierbei erfindungsgemäß eine außerordentlich schnelle zeitliche Auswertung zur Verfügung gestellt werden.

Mit dieser Erfindung können beispielsweise auf Basis einer zentralen Spannungs- bzw. Strommessung an der Einspeisung stromstarke Störlichtbögen, beispielsweise in Schalt- und Verteileranlagen, z.B. in der Niederspannung, schnell detektiert werden.

Die Erfindung kann insbesondere vorteilhaft in bzw. im Zusammenwirken mit Leistungsschaltern oder Kurzschließern eingesetzt werden.

Eine aufwendige Installation von Lichtwellenleitern in Anlagen zur Störlichtbogenerkennung ist nicht erforderlich. Die Spannungs- / Strommessung kann zentral realisiert und ggf. synergetisch von weiteren Betriebsmitteln genutzt werden.

Im Weiteren ist eine Implementierung in vorhandene Schalt-und Verteileranalgen einfach möglich, da ein erfindungsgemäßes Detektionssystem beispielsweise lediglich zentral eingebaut werden kann und keine Installation in einzelnen, zu schützenden Zellen erforderlich ist.

Die Erfindung kann als Baugruppe mit zentraler Spannungs- und Stromermittlung realisiert sein.

Die bisher am Markt etablierten Detektionssysteme basieren auf einer optischen Fehlererkennung und weisen somit Potential zu einer Fehlauslösung durch die Einwirkung von Fremdlicht (z.B. Blitzlicht) auf. Bei der erfindungsgemäßen Lösung auf Grundlage einer Spannungs- bzw. Strommessung ist dieses Gefahrenpotential nicht vorhanden.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| A | Ampere |
|---|---|
| ABG I | Abgang I |
| ABG II | Abgang II |
| ABG III | Abgang III |
| ALT 1 | Abgangs-Kabel 1 |
| ALT 2 | Abgangs-Kabel 2 |
| ALT 3 | Abgangs-Kabel 3 |
| ARB | Arbeitsbereich |
| AE | Auswerteeinheit |
| AE1 | Erste Auswerte(teil)einheit |
| AE2 | Zweite Auswerte(teil)einheit |
| ELT1 | Einspeise-Kabel 1 |
| ESCH | Einspeise-Schalter, Leistungsschalter |
| I | elektrischer Strom |
| $i_{lb}$ | Lichtbogenstrom |
| im | Stromwert, gemessen |
| $i'_m$ | Wert der Änderung des Stromwertes |
| KS | Kurzschließer |
| $L_{BM}$ | Induktivität Verbraucher |

| $L_{EK}$ | Induktivität Einspeise-Kabel |
| L1 | Stromschiene, Leiter 1 |
| L2 | Stromschiene, Leiter 2 |
| L3 | Stromschiene, Leiter 3 |
| ms | Millisekunden |
| NSE | Niederspannungseinspeisung |
| $R_{BM}$ | Widerstand Verbraucher |
| $R_{EK}$ | Widerstand Einspeise-Kabel |
| SEE | Störlichtbogenerkennungseinheit |
| SEI1 | Stromsensor |
| SEI2 | Stromsensor |
| SEI3 | Stromsensor |
| SEU1 | Spannungssensor |
| SEU2 | Spannungssensor |
| SEU3 | Spannungssensor |
| SLES | Störlichtbogenerkennungssignal |
| SI | Sicherung |
| SS | Sammelschiene |
| SVA | Schalt- und Verteilanlage |
| SW1 | Schwellwert Lichtbogenspannung |
| SW2 | Schwellwert Lichtbogenspannung |
| SW3 | Schwellwert Stromfreigabe |
| SW4 | Schwellwert Differenz |
| t | Zeit |
| U | elektrische Spannung |
| $U_{lb}$ | Lichtbogenspannung |
| um | Spannungswert, gemessen |
| $u_n$ | Spannungswert, Energiequelle / Netz |
| V | Volt |
| & | UND-Einheit |
| 1 | Schritt 1 - fortlauf. Berechnung |
| 2 | Schritt 2 - Schwellwertvergleich |
| 3 | Schritt 3 - Abgabe Störlichtbogenerkennungssignal |
| 4 | Schritt 4 - Kein Störlichtbogen |
| 100 | Energiequelle |
| 200 | Netzzugang / Einspeise-Kabel |
| 300 | Verbraucher / Betriebsmittel / Energiesenke |
| 400 | Lichtbogen |
| 500 | Überwachter Bereich |
| 600 | Meßpunkte |

**Patentansprüche**

1. Störlichtbogenerkennungseinheit für einen elektrischen Niederspannungsstromkreis, aufweisend mindestens einen Spannungssensor, zur periodischen Ermittlung von elektrischen Spannungswerten (u(n), u(k)) des elektrischen Stromkreises,
der mit einer Auswerteeinheit verbunden ist, die derart ausgestaltet ist,
dass fortlaufend eine erste Hälfte einer ersten Anzahl Spanungswerte (u(n), u(k)) zu einer ersten Teilsumme (TS1) und die zweite Hälfte an Spannungswerten (u(n), u(k)) zu einer zweiten Teilsumme (TS2) aufsummiert wird,
eine Differenz (DU) beider Teilsummen ermittelt wird,
dass entweder einerseits die Differenz (DU) oder der Betrag der Differenz (DU) mit einem ersten Schwellwert (SW1) verglichen wird und bei dessen Überschreitung ein Störlichtbogenerkennungssignal (SLES) abgegeben wird oder/und andererseits die Differenz (DU) mit einem zweiten Schwellwert (SW2) verglichen wird und bei dessen Unterschreitung ein Störlichtbogenerkennungssignal (SLES) abgegeben wird.

2. Störlichtbogenerkennungseinheit gemäß Patentanspruch 1,
**dadurch gekennzeichnet,**

**dass** der Niederspannungsstromkreis ein Wechselstromkreis ist.

3. Störlichtbogenerkennungseinheit nach einem der vorhergehenden Patentansprüche,
**dadurch gekennzeichnet,**
**dass** die Spannungswerte (u(n), u(k)) mit einem Vielfachen der Frequenz des Niederspannungsstromkreises ermittelt werden oder mit einer Abtastfrequenz im Bereich von 1-200 KHz.

4. Störlichtbogenerkennungseinheit nach einem der vorhergehenden Patentansprüche,
**dadurch gekennzeichnet,**
**dass** die erste Anzahl durch ein Zeitfenster bestimmt ist.

5. Störlichtbogenerkennungseinheit nach einem der vorhergehenden Patentansprüche,
**dadurch gekennzeichnet,**
**dass** für jeden ermittelten Spannungswert (u(n), u(k)) eine Differenzermittlung (DU) durchgeführt wird.

6. Störlichtbogenerkennungseinheit nach einem der vorhergehenden Patentansprüche,
**dadurch gekennzeichnet,**
**dass** die Differenz (DU) mit einem Faktor multipliziert wird, dessen Größe von der ersten Anzahl abhängig ist.

7. Störlichtbogenerkennungseinheit nach Patentanspruch 6,
**dadurch gekennzeichnet,**
**dass** der Faktor ein Produkt aus einer Konstanten und dem Kehrwert der ersten Anzahl ist.

8. Störlichtbogenerkennungseinheit nach einem der vorhergehenden Patentansprüche,
**dadurch gekennzeichnet,**
**dass** der erste Schwellwert (SW1) und der zweite Schwellwert (SW2) den gleichen Betrag aufweisen.

9. Störlichtbogenerkennungseinheit nach einem der vorhergehenden Patentansprüche,
**dadurch gekennzeichnet,**
**dass** fortlaufend eine zweite Anzahl Differenzen (DU) zu einer Differenzensumme (DS) aufsummiert wird, an Stelle der Differenz (DU) die Differenzsumme (DS) mit dem ersten oder zweiten Schwellwert (SW1, SW2) verglichen wird und bei dessen Über- bzw. Unterschreitung ein Störlichtbogenerkennungssignal (SLES) abgegeben wird.

10. Störlichtbogenerkennungseinheit nach einem der vorhergehenden Patentansprüche,
**dadurch gekennzeichnet,**
**dass** mindestens ein Stromsensor vorgesehen ist, der periodisch elektrische Stromwerte des Stromkreises ermittelt, der mit der Auswerteeinheit verbunden ist, die derart ausgestaltet ist,
**dass** fortlaufend der ermittelte Stromwert mit einem dritten Schwellwert (SW3) verglichen wird und erst bei dessen Überschreitung ein Störlichtbogenerkennungssignal (SLES) abgegeben wird.

11. Leistungsschalter für einen elektrischen Niederspannungsstromkreis, aufweisend eine Störlichtbogenerkennungseinheit gemäß einem der Patentansprüche 1 bis 10, die mit dem Leistungsschalter verbunden ist und die derart ausgestaltet sind, dass bei Abgabe eines Störlichtbogenerkennungssignals (SLES) der Leistungsschalter auslöst, um den elektrischen Stromkreis zu unterbrechen.

12. Kurzschließer, aufweisend eine Störlichtbogenerkennungseinheit gemäß einem der Patentansprüche 1 bis 10, die mit dem Kurzschließer verbunden ist, und die derart ausgestaltet sind, dass bei Abgabe eines Störlichtbogenerkennungssignals (SLES) der Kurzschließer den elektrischen Stromkreis kurzschließt, um ein Löschen des Störlichtbogen zu bewirken.

13. Verfahren zur Störlichtbogenerkennung für einen elektrischen Stromkreis,
bei dem periodisch elektrische Spannungswerten (u(n), u(k)) des elektrischen Stromkreises ermittelt werden,
fortlaufend eine erste Hälfte einer ersten Anzahl Spanungswerte (u(n), u(k)) zu einer ersten Teilsumme (TS1) und die zweite Hälfte an Spannungswerten (u(n), u(k)) zu einer zweiten Teilsumme (TS2) aufsummiert wird,
eine Differenz (DU) beider Teilsummen ermittelt wird,
dass entweder einerseits die Differenz (DU) oder der Betrag der Differenz (DU) mit einem ersten Schwellwert (SW1) verglichen wird und bei dessen Überschreitung ein Störlichtbogenerkennungssignal (SLES) abgegeben wird oder/und andererseits die Differenz (DU) mit einem zweiten Schwellwert (SW2) verglichen wird und bei dessen Unterschreitung ein Störlichtbogenerkennungssignal (SLES) abgegeben wird.

14. Verfahren nach Patentanspruch 13,
**dadurch gekennzeichnet,**
**dass** fortlaufend eine zweite Anzahl Differenzen (DU) zu einer Differenzensumme (DS) aufsummiert wird, an Stelle der Differenz (DU) die Differenzsumme (DS) mit dem ersten oder zweiten Schwellwert (SW1, SW2) verglichen wird und bei dessen Über- bzw. Unterschreitung ein Störlichtbogenerkennungssignal (SLES) abgegeben wird.

15. Verfahren nach Patentanspruch 13 oder 14,
**dadurch gekennzeichnet,**
**dass** die Spannungswerte (u(n), u(k)) mit einem Vielfachen der Frequenz des Niederspannungsstromkreises ermittelt werden oder
mit einer Abtastfrequenz im Bereich von 1-100 KHz oder
**dass** die Differenz (DU) mit einem Faktor multipliziert wird, dessen Größe von der ersten Anzahl abhängig ist, insbesondere dass der Faktor ein Produkt aus einer Konstanten und dem Kehrwert der ersten Anzahl ist.

16. Verfahren nach Patentanspruch 13, 14 oder 15,
**dadurch gekennzeichnet,**
**dass** das Störlichtbogenerkennungssignal zur Unterbrechung oder zum Kurzschluss des elektrischen Stromkreises verwendet wird.

## FIG 1

## FIG 2

## FIG 3

## FIG 4

# FIG 5

# FIG 6

FIG 7

EP 3 252 900 A1

Europäisches
Patentamt

European
Patent Office

Office européen
des brevets

# EUROPÄISCHER RECHERCHENBERICHT

**Nummer der Anmeldung**

EP 17 16 8392

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 2 916 455 A1 (SIEMENS AG [DE]) 9. September 2015 (2015-09-09) * Zusammenfassung; Ansprüche 1-9 * ----- | 1-16 | INV. H02H1/00 G01R31/12 |
| A | EP 0 639 879 A2 (EATON CORP [US]) 22. Februar 1995 (1995-02-22) * Zusammenfassung; Ansprüche 1-10 * ----- | 1-16 | |
| A | US 2016/003883 A1 (CHAINTREUIL NICOLAS [FR] ET AL) 7. Januar 2016 (2016-01-07) * Zusammenfassung; Ansprüche 1-20 * ----- | 1-16 | |
| A | US 7 656 626 B2 (CROUZET AUTOMATISMES [FR]) 2. Februar 2010 (2010-02-02) * Zusammenfassung; Ansprüche 1-50 * ----- | 1-16 | |

**RECHERCHIERTE SACHGEBIETE (IPC)**

H02H
G01R

Der vorliegende Recherchenbericht wurde für alle Patentansprüche erstellt

| Recherchenort | Abschlußdatum der Recherche | Prüfer |
|---|---|---|
| München | 5. Oktober 2017 | Lehnberg, Christian |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**  EP 17 16 8392

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-10-2017

| Im Recherchenbericht angeführtes Patentdokument | Datum der Veröffentlichung | Mitglied(er) der Patentfamilie | Datum der Veröffentlichung |
|---|---|---|---|
| EP 2916455 A1 | 09-09-2015 | CN 104898008 A<br>DE 102014204253 A1<br>EP 2916455 A1 | 09-09-2015<br>10-09-2015<br>09-09-2015 |
| EP 0639879 A2 | 22-02-1995 | AU 674979 B2<br>CA 2130534 A1<br>CN 1129809 A<br>DE 69414328 D1<br>DE 69414328 T2<br>EP 0639879 A2<br>ES 2124823 T3<br>JP H07236224 A<br>US 5452223 A<br>US 5561605 A<br>ZA 9406334 B | 16-01-1997<br>21-02-1995<br>28-08-1996<br>10-12-1998<br>17-06-1999<br>22-02-1995<br>16-02-1999<br>05-09-1995<br>19-09-1995<br>01-10-1996<br>22-03-1995 |
| US 2016003883 A1 | 07-01-2016 | EP 2959303 A1<br>FR 3002644 A1<br>US 2016003883 A1<br>WO 2014128244 A1 | 30-12-2015<br>29-08-2014<br>07-01-2016<br>28-08-2014 |
| US 7656626 B2 | 02-02-2010 | EP 1845599 A1<br>FR 2899718 A1<br>US 2007242399 A1 | 17-10-2007<br>12-10-2007<br>18-10-2007 |

EPO FORM P0461

Für nähere Einzelheiten zu diesem Anhang : siehe Amtsblatt des Europäischen Patentamts, Nr.12/82